(19)

Europäisches
Patentamt
European
Patent Office
Office européen
des brevets

(11) **EP 2 377 245 B1**

(12) **EUROPEAN PATENT SPECIFICATION**

(45) Date of publication and mention
of the grant of the patent:
**24.07.2013 Bulletin 2013/30**

(51) Int Cl.:
***H03H 9/58*** *(2006.01)*

(21) Application number: **09801402.0**

(86) International application number:
**PCT/EP2009/008891**

(22) Date of filing: **11.12.2009**

(87) International publication number:
**WO 2010/066451 (17.06.2010 Gazette 2010/24)**

(54) **FILTERING CIRCUIT WITH COUPLED BAW RESONATORS AND HAVING IMPEDANCE MATCHING ADAPTATION**

FILTERSCHALTUNG MIT GEKOPPELTEN BAW-RESONATOREN UND MIT IMPEDANZANPASSUNGS-ADAPTION

CIRCUIT DE FILTRAGE À RÉSONATEURS À ONDES ACOUSTIQUES DE VOLUME (BAW) COUPLÉS, À ADAPTATION D'IMPÉDANCE

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **12.12.2008 FR 0806971**

(43) Date of publication of application:
**19.10.2011 Bulletin 2011/42**

(73) Proprietor: **STMicroelectronics SA
92120 Montrouge (FR)**

(72) Inventors:
• **CARPENTIER, Jean-François
38100 Grenoble (FR)**

• **BAR, Pierre
38000 Grenoble (FR)**
• **VOLATIER, Alexandre
Apopka, FL 32703 (US)**

(74) Representative: **Schuffenecker, Thierry
Cabinet Thierry Schuffenecker
120, Chemin de la Maure
06800 Cagnes sur Mer (FR)**

(56) References cited:
**EP-A- 1 528 675    DE-A1-102008 051 244**

## Description

## Technical field of the invention

The present invention concerns the field of integrated electronic circuits and micro-systems comprising Bulk Acoustic Wave resonators (BAW).

## State of the art

The interest for using acoustic resonators is growing with telecommunications development and especially with the mobile telephony that requires miniaturized efficient filtering circuits. The use of acoustic resonators enables to achieve high quality factors in the filtering circuits..

For few years, the BAW (*Bulk Acoustic Resonator*) type acoustic resonators have generated a particular interest for the manufacturing of the RF filtering circuits owing to their intrinsic qualities and to their integration ease that the SAW (*Surface Acoustic Wave*) type resonators cannot offer.

Beside of their integration within a semi-conductor circuit, BAW type integrated circuits are particularly interesting owing to the multiple combining possibilities that they offer for manufacturing complex filtering circuits.

The first assemblies of acoustic resonators are based on architectures of the type « ladder » or of the type « lattice". These topologies enable achievement of high degree filtering functions that have the drawback however to exhibit an occupation surface area not neglegible on the silicon.

In order to reduce the room needed on the substrate and according to a known technique denominated in English SMR Coupled *Filters (SCF) and described for example in the document referenced as* « Bulk Acoustic Wave Coupled Resonators Filters» par K.M. Lakin, in 8A-1, 2002 IEEE International Frequency Control Symposium, *wherein* stacked resonators share a common electrode.

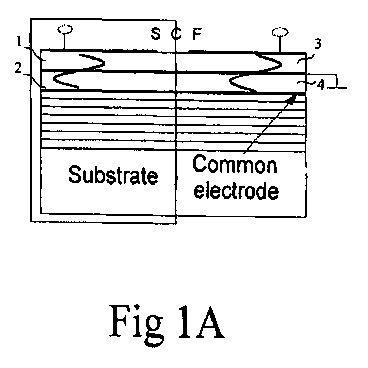

The figure 1A illustrates such a structure comprising two sections, left and right respectively, each section comprising a stack of two resonators 1-2 and 3-4. Each pair of resonators 1-2 (3-4 respectively) has a common electrode ensuring therefore for each resonator an operation in reversed phasing to each other. Thus, each of the sections constitutes one pole and a two poles filter is therefore achieved by means of the left and right two sections.

The pass-band bandwidth obtained by this type of filter is however not sufficient for the modern applications of the mobile telephony such as the WCDMA..

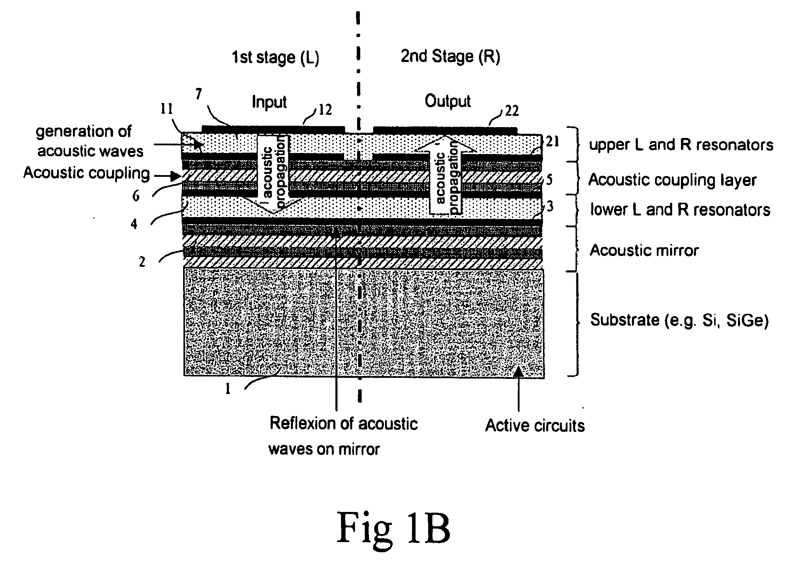

Later, the introduction of a coupling within each of the sections of the resonator shown in the figure **1B** has been researched through one or more specific coupling layers, and this has leaded to the achievement of the structure denominated *Coupled Resonators Filter* (CRF) as shown in this figure. In the shown case, the acoustic isolation of the filter is implemented by a Bragg reflector.

The circuit comprises as shown in the figure, two structures LEFT and RIGHT respectively perfectly symmetrical to a vertical axis passing through the middle of the figure.

A first section - or LEFT section - breaks down into an upper resonator comprising two electrodes, a lower electrode 11 and a upper 12 electrode respectively, sandwiching a layer 7 made of piezoelectric material. The assembly is located above a layer 6 implementing an acoustic coupling, which layer is placed on a lower resonator comprising two electrodes, a lower electrode 3 and an upper electrode 5 respectively, sandwiching a layer 4 of piezoelectric material.

On the other side of the vertical axis, and following a perfect symmetry with the first section, the circuit comprises a second stage - or right section - that breaks down into an upper resonator and a lower resonator separated by the acoustic coupling layer 6. The upper resonator breaks into two electrodes, a lower electrode 21 (possibly connected to the electrode 11) and an upper electrode 22 sandwiching the layer 7. The lower resonator breaks down into two electrodes 3 and 5 sandwiching the layer 4.

The assembly made of two sections is placed on an acoustic mirror 2 (or a membrane), the acoustic mirror being placed on a substrate 1 of silicon or SiGe possibly comprising logic or analogue circuits in MOS or CMOS technology..

This structure denominated CFR is well known from a man skilled in the art and it is not necessary to describe such a structure further, especially its manufacturing process.

It will be merely reminded that the upper resonator (electrodes 11 and 12 and the layer 7) receives an electrical signal to be filtered and converts the electrical signal into an acoustic wave that is a bulky wave. This bulky wave is transmitted by an acoustic coupling through the layer 6 to the lower resonator of the first stage wherein the bulky wave is converted into an electrical signal transmitted to the lower resonator of the second section since this resonator shares the same electrodes of the lower resonator of the first section.

The bulky wave is then transmitted by acoustic coupling through the layer 6 to the upper resonator of the second section located on the right of the figure 1B.

By means of this CRF structure a filtering response is achieved that exhibits four resonance poles and a bandwidth greater than one exhibited for a SCF filter. The acoustic coupling can be optimized to achieve a coupling said «critical» that is the best tradeoff between the ripple ratio and the insertion loss of the filter. It closely depends on the features and the thicknesses of the different layers constituting the CRF, in particular of the intermediate coupling mirror.

It will be referred especially as to the following reference for further details : « Coupled Resonators Filters », de K.M. LAKIN, in paper 3D-5, IEEE 2002 Ultrasonics Symposium , October 8-11

Such a known CRF structure exhibits great advantages especially regarding the room saving obtained on the silicon substrate.

Besides, it has been sought to implement the function of impedance transformation and mode conversion between the antenna and the electronic circuits located downstream to the filtering circuit.

The filters of SAW type, not integrated, with limited operating power and frequency bandwidth achieve these functions but they sometimes need cumbersome external inductances.

For the CRF, a first known solution consists of optimizing the surface area of the electrodes in each of the sections of the structure in order to change the equivalent electric capacitance and therefore to increase the impedance value exhibited at the output.

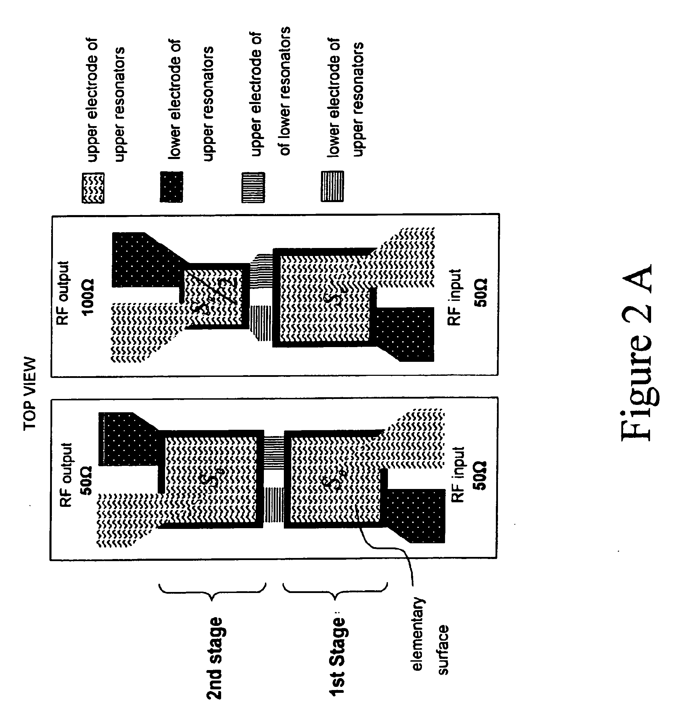

In the figure 2A, it is shown that the size of the right section is reduced by a factor of two, which enables achievement of an impedance matching of the type 50 Ω-100 Ω.

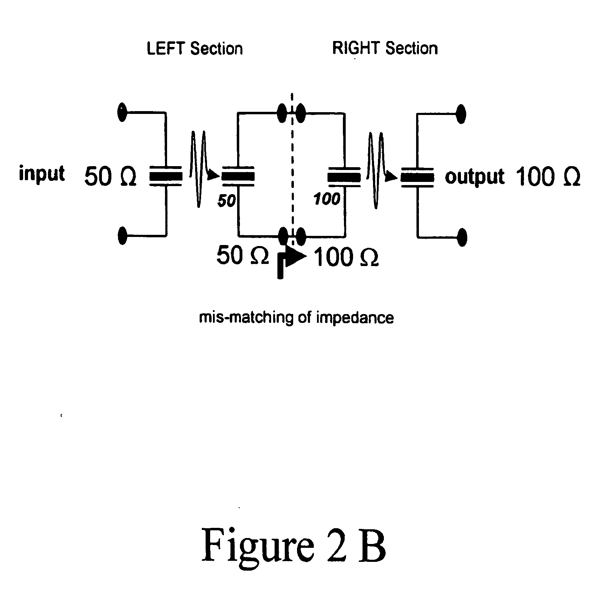

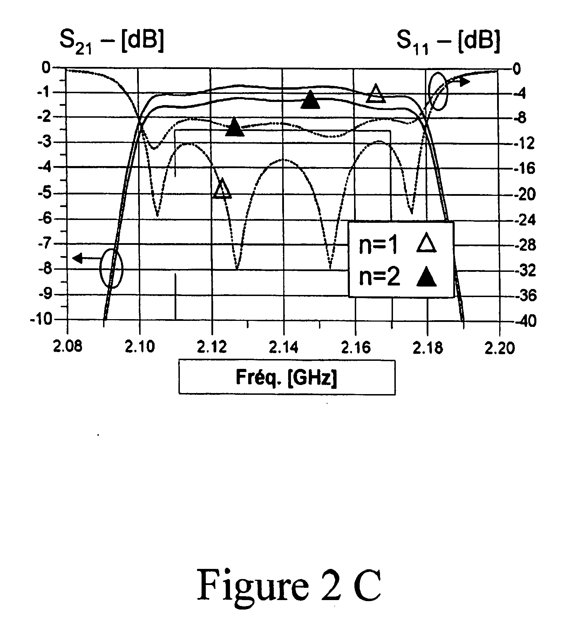

However, in the figure 2B it is shown that the change of the surface area leads to introduce supplemental insertion losses owing to the defect of matching within the filtering circuit itself, especially at the level of electric interconnection between the two sections as illustrated in the figure 2C.

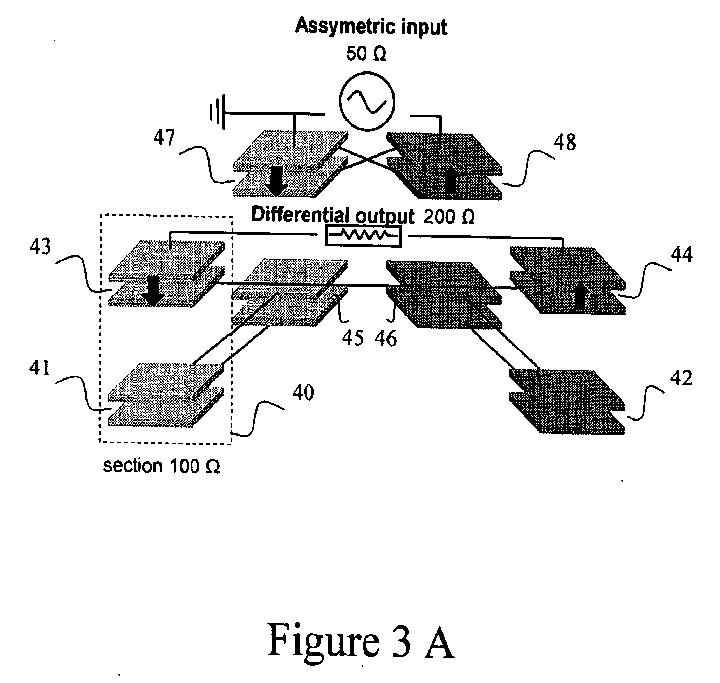

For a transformation ratio equal to 4 (or to ¼), it is possible to remove the insertion losses related to this mismatching. The known technique consists of using two identical filtering paths comprising two sections (thus four resonators) and to electrically interconnect the two upper resonators for each of the sections in a satisfactory manner (in series or in parallel). The figure 3A shows the manner of electrically interconnecting these resonators. The filter comprises two sections, LEFT and RIGHT sections respectively, each section having two pairs of elementary resonators. The LEFT section comprises the lower pair 41-42 and the upper pair 43-44, whereas the RIGHT section comprises the lower pair 45-46 and the upper pair 47-48. It is also built an electrical connection between each of the lower and upper electrodes of the two resonators 41 and 45, and in the same manner for the two resonators 42 and 46. The lower electrodes of the two resonators of the LEFT section are also connected and more over the two upper resonators of the right part are connected in an anti-parallel way.

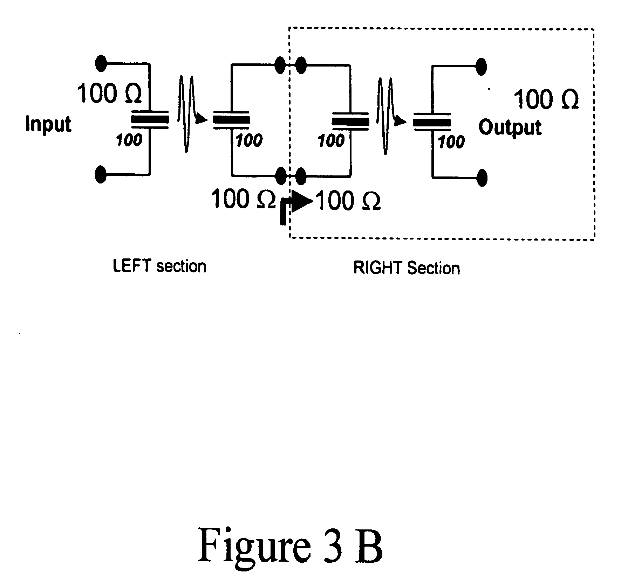

The figure 3B shows that in each of the two paths that are parts of the filter, the impedance matching is achieved between the two sections at the level of the lower resonators 41-45 and 42-46. In this way, a structure of filter is built that guarantee an efficient impedance matching (stationary wave ratio (SWR) < 2) and a transformation ratio equal to four.

It will be referred more particularly to the following reference for further details: «Single-to-balanced Filters for Mobile Phones Using Coupled Resonator BAW technology » G. Fattinger et al. IEEE Ultrasonics Symposium IEEE, 2004.

Based on the same principle, the patent application WO 2005/046052 A1 « Impedance Transformation Ratio Control in Film Acoustically-Coupled Transformers » proposes to achieve several other transformation ratios by adding more than two paths made of two sections in the filter CRF. This results in using resonators with surface areas very reduced, which renders complex the optimization of the electrical performance. This also contributes to multiply the number of the electrical interconnections between the upper resonators and to increase therefore the surface area of the filter and its insertion losses.

The CFR structure has the important advantage to enable an impedance transformation and a mode conversion. However, depending on the transformation ratio to be achieved, the structure is more or less efficient in terms of insertion losses and SWR.

It cannot be envisage d therefore to achieve all the possible combinations of impedance matching.

More over, and this is an even more unacceptable drawback, the known CFR structure requires, to be carried out, a perfect mastering of the manufacturing process of the various layer s constituting the component. It has been observed in laboratory that low dispersic ns at the level of the electrode layers, the piezoelectric layers, but also at the level of the coupling layer(s), result in an unacceptable offset of the resonance frequencies of the upper and lower resonators of a same section, rendering irreversibly the filter response not compliant with the desired telecommunication standard (GSM bands, UMTS bands etc) and thus rendering the filter unusable.

There is here a ma or constraint on the manufacturing process of these structures, expensive to manufacture and that may impediment the industrial development of such structures.

The present inventior aims to remedy such deficiencies.

The following document is prior art:

EP 1 528 675 discloses an acoustically-coupled transformer including a stacked bulked acoustic resonator (SBAR) having a stacked pair of film bulk acoustic resonators (FBARs) with an acoustic decoupler between them.

## Summary of the invention

The present invention aims to propose a filtering circuit based on coupled bulky acoustic wave resonators, easy to integrate in a semiconductor substrate, and that minimizes the effect of the variations exhibited by the manufacturing process of the various layers of the circuit .

Another object of the invention is to provide a filtering circuit with coupled acoustic wave resonators offering multiple possibilities of impedance matching and transformation while minimizing the insertion losses.

It is a third object of the present invention to provide a filtering circuit easy to integrate in a semiconductor product and that does not require a transformer of BALUN type.

It is another object of the present invention to provide a filtering circuit suitable to build the reception and transmission circuit for the mobile telecommunication.

The invention achieves these objects by means of a filtering circuit based on coupled BAW resonators comprising:

- a substrate;
- a membrane or an acoustic mirror destined to operate as mechanical support of the resonators and to isolate the acoustic waves of the substrate ;
- a first structure (LEFT) comprising an upper resonator and a lower resonator coupled to each other by means of at least one acoustic coupling layer, the said upper and lower resonators having a first section (A1) ;
- a second structure (RIGHT) comprising an upper resonator and a lower resonator coupled to each other by means of at least one acoustic coupling layer, the said upper and lower resonators of the said second structure having a second section (A2) ;

The electric interconnection between the two structures is characterized in that it comprises at least one metallic inter-stage connection between the lower resonator of one of the structures and the upper resonator of the other structure. This connection will be denominated, through inter-stage connection or through via.

Such a connection between the two structures which basically differs from the conventional connection between the lower resonators, allows significant compensation of the dispersions exhibited by the manufacturing process of the filtering circuit.

It results thereof, which is a major advantage, a significant release of the constraints exerted on the manufacturing process.

In a particular embodiment, the upper and lower resonators of the left and right structures exhibit a piezoelectric layer having a thickness selected so that in particular an impedance matching between the two resonators connected by the through inter-stage connection is achieved.

Thus, it results thereof multiple possibilities of impedance matching since the section area of the resonators of the right structure can be arbitrary varied to match the structure to the impedances of the electronic circuits placed downstream, regardless of modifying concurrently the upper and/or lower piezoelectric layers in order to ensure the impedance matching at the level of the connection between the two structures of the CRF filter.

In a particular embodiment, the resonators are resonators of the Bulk Acoustic Wave (B.A.W.) type that can be built by techniques such as thin film deposition, sputtering, vaporization under vacuum or Chemical Vaporization deposition (CVD).

The invention also provides a manufacturing method of a filtering circuit with coupled resonators comprising the following steps:

- providing a substrate;
- placing an acoustic mirror above the substrate or the membrane;
- placing a first (LEFT) and a second (RIGHT) structure, each structure comprising a lower resonator having electrodes (made of one or more metallic materials) and a piezoelectric layer ;
- disposing at least one acoustic coupling layer;
- disposing an upper resonator having electrodes (made of one or more metallic materials) and a second piezoelectric layer;
- disposing metallic vias placed between the resonators and ensuring a trough inter-stage electric connection between a lower resonator of a structure and an upper resonator of the other structure.

**Description of the drawings**

Other features, purposes and advantages of the invention will appear from the reading of the description and the drawing here below given only as no limiting examples. In the attached drawings :

The figures 1A and 1B show a basis structure of a known filter of the type CRF.

The figures 2A et 2B illustrate respectively a top view of a known filtering circuit implementing an impedance matching of the type 50 $\Omega$ - 100 $\Omega$ and its equivalent electric scheme.

The figure 2C shows the losses caused by the mismatching resulting from the surface area change of the right section.

The figures 3A and 3B illustrate respectively a known CFR structure ensuring an impedance matching with a transformation ratio of four without supplemental losses, and its equivalent electrical scheme.

The figure 4A shows an embodiment of the structure according to the present invention.

The figure 4B illustrates an equivalent scheme of such a structure, showing the impedance transformation achieved with a ratio of two.

The figure 4C shows a particular embodiment of the stacks of layers of a circuit that implement a transformation ratio equal to two without supplemental electric losses.

The figure 4D illustrates a particular embodiment of a circuit layout that implements a transformation ratio equal to two without supplemental electrical losses.

The figure 4E is a comparison between the performance curve of the embodiment of the CRF filter with an impedance transformation ratio of 2 as shown in the figures 4.B et 4.C and the performance curve obtained with the known embodiment shown in figure 2.A. This example shows the advantages of the present invention that does not degrade the electric performance of the filter in the case wherein an impedance transformation is achieved.

The figure 5 shows a particular embodiment of a filtering circuit wherein the desired impedance transformation ratio has been designated by $\Delta$ and the input impedance of a filter CRF has been designated by $Z_0$

The figure 6 illustrates another example of architecture of filtering circuit according to the present invention that enables when it is combined with the known solution to amplify the transformation ratio.

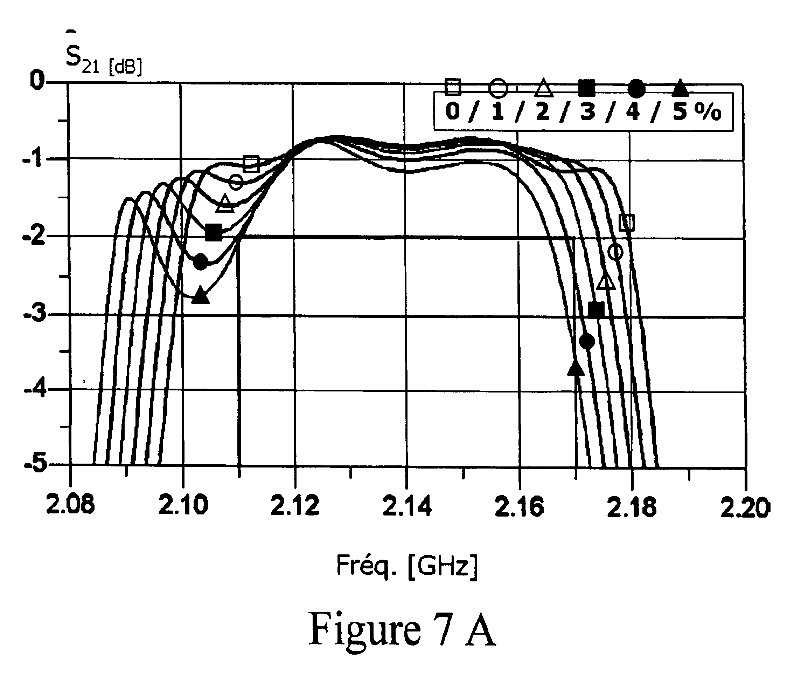

For example, the figure 7A shows the effect of a dispersion higher than 1 % of the thickness of one of the layers that compose the coupling mirror on the transmission response of a CRF filter made of two sections. It is observed an important increase of the ripples ratio and a reduction of the actual pass-band bandwidth relative to a desired reference pass-band bandwidth that corresponds to a particular standard.

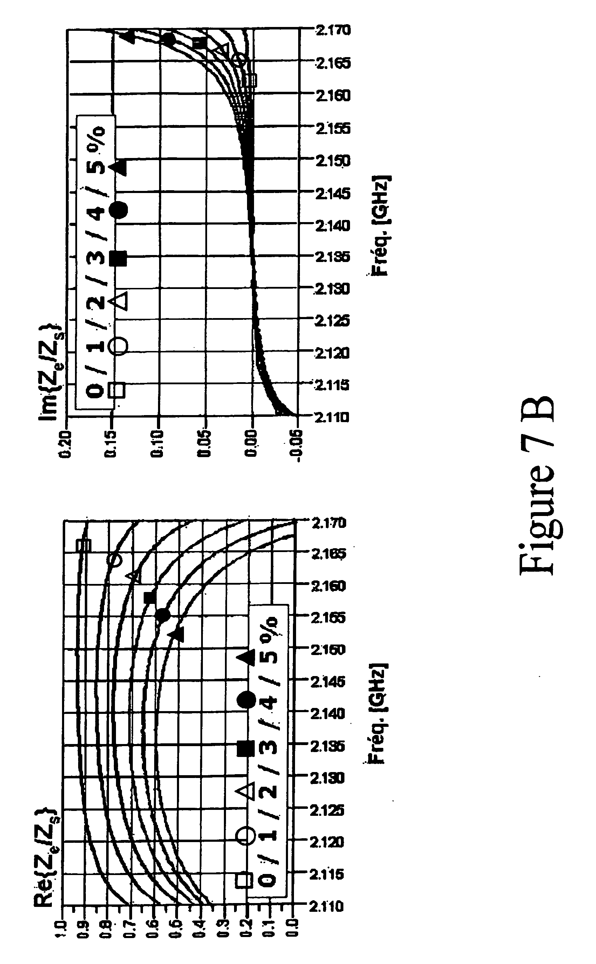

The figure 7B shows the effect of this same technological dispersion on the impedance transformation ratio exhibited by a section of the CRF filter.

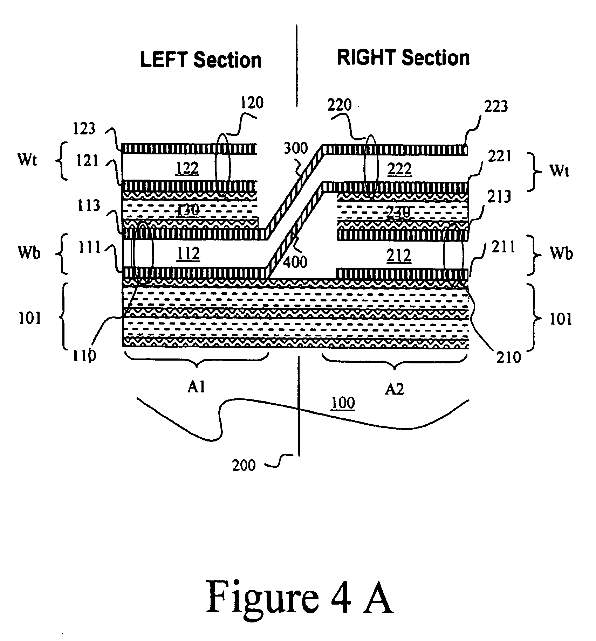

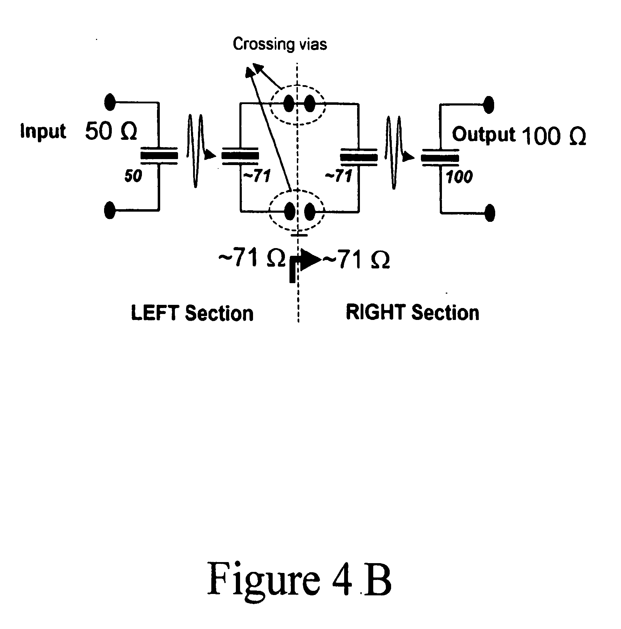

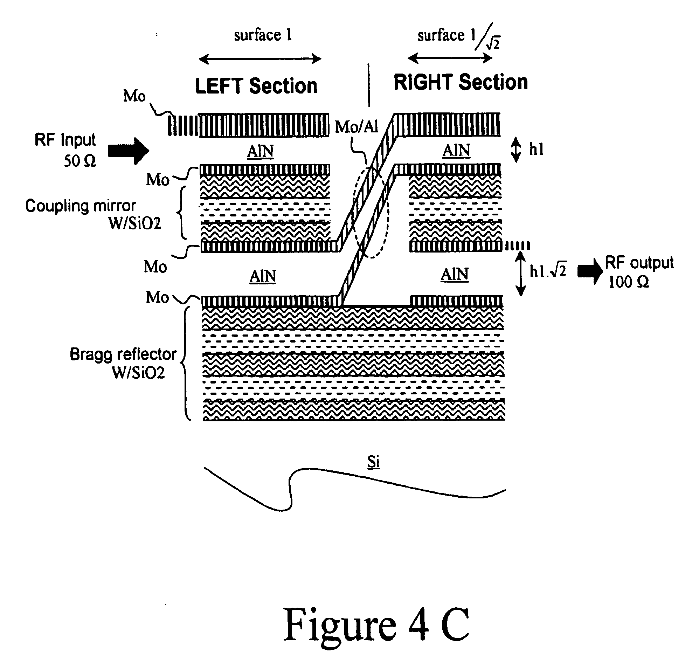

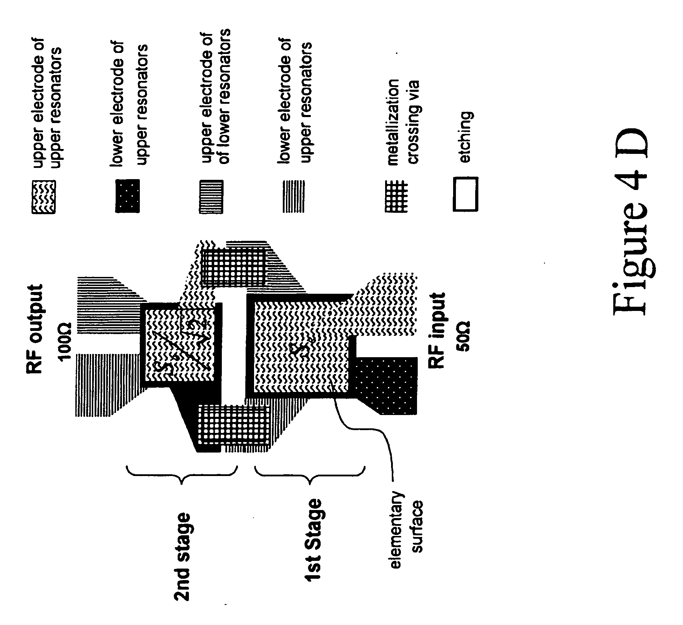

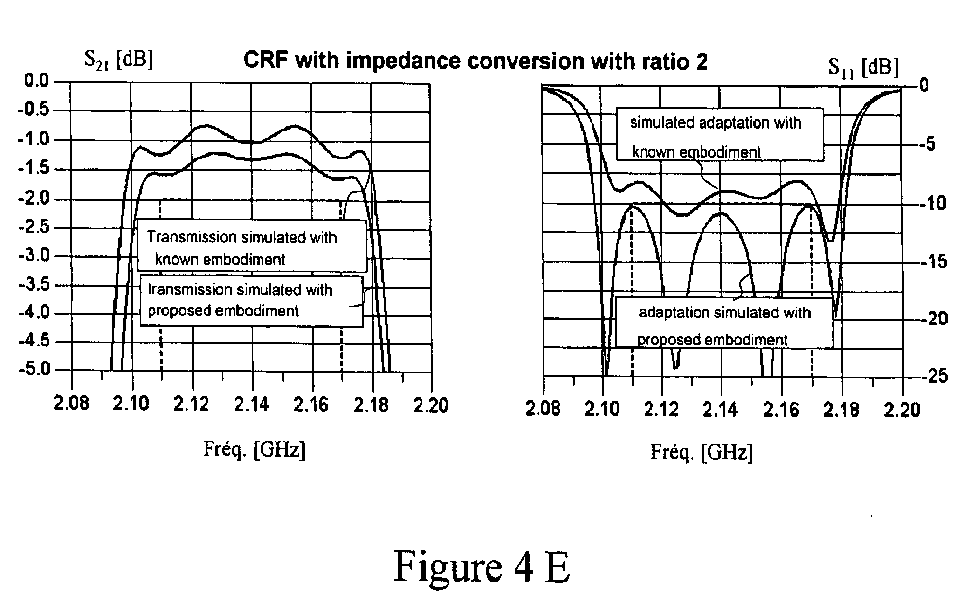

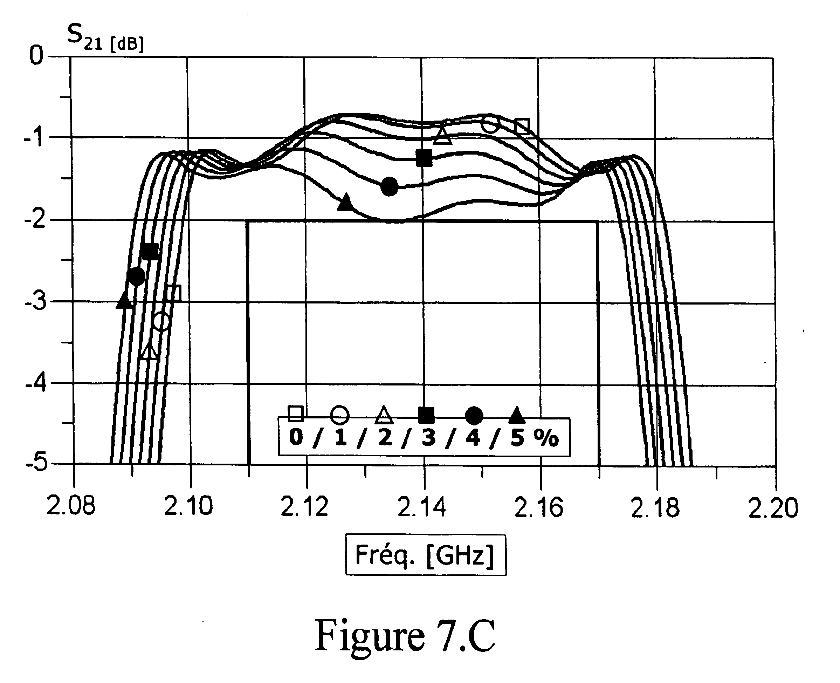

The figure 7C illustrates the effect of this technological dispersion on the transmission response of the filter built with the method of the figure.4.A. The invention enables to diminish very significantly the negative effects of the dispersions.

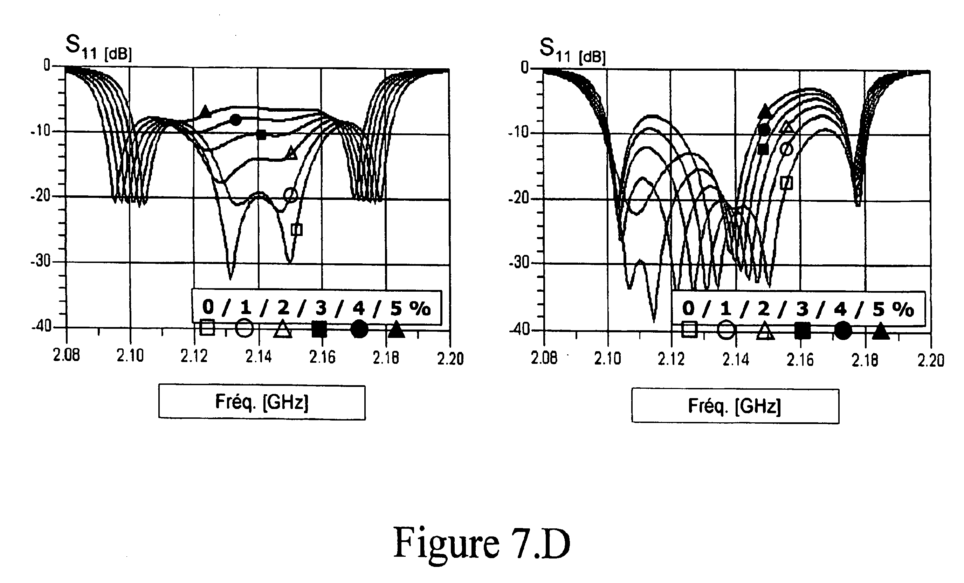

The figure 7D illustrates the effect of this technological dispersion on the reflection response of the filter built with the method of the figure 4A in comparison of the known embodiment. The invention enables to reduce the impedance mismatching in the pass-band bandwidth of the filter.

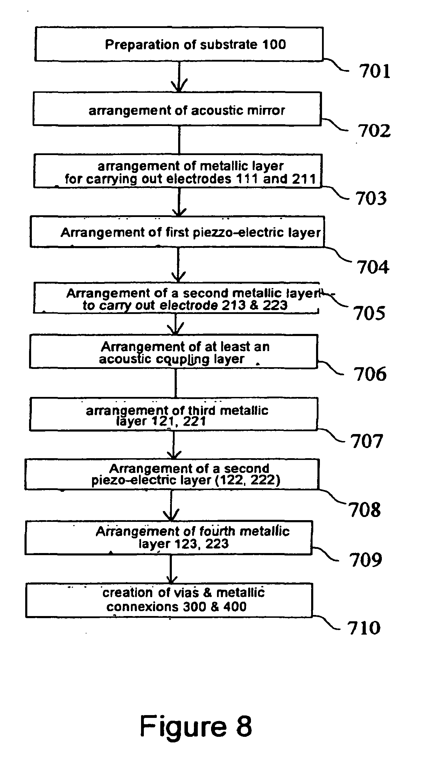

The figure 8 illustrates an embodiment of a manufacturing method according to the present invention.

**Description of a preferred embodiment**

The filtering circuit that will be described is particularly suited to the manufacturing of RF filtering circuits destined to the mobile telephony such as GSM (Global System for Mobile Communications) or WCDMA (Wideband Code Division Multiple Access) for example.

The circuit according to the invention has architecture of CRF type comprising a stack of acoustic resonators disposed on a Bragg mirror or a membrane. It is reminded that an acoustic mirror comprises a stack of layers with different acoustic impedances, the thicknesses thereof being optimized. The alternance of two distinct layers, one of which exhibits a high acoustic impedance and the other a low acoustic impedance implements the reflection function of the acoustic waves.

Referring to the figure 4A, the manufacturing of a filtering circuit with coupled resonators according to the present invention is described.

The filtering circuit is made of a substrate of silicon type 100, built in silicon (Si), in Gallium Arsenide (GaAs), in glass or in ceramic. This substrate 100 may comprise conventional MOS structures enabling to implement logic and/or analogue circuits that are not part of the present invention and that will not be described further.

The filtering circuit comprises further, located above the substrate 100, a reflecting mirror 101 - or BRAGG mirror - that is made of a stack of layers having different acoustic properties, the said stack being disposed on the substrate 100. The Bragg reflector ensures a minimal attenuation of the acoustic waves within the substrate 100. Alternatively, it will be provided a membrane to isolate the filtering circuit from the substrate.

The filtering circuit comprises more over, above the acoustic mirror, a set of four resonators of BAW type shared into two asymmetrical structures, LEFT and RIGHT respectively, relative to a vertical axis designated by 200 on the figure 4A.

The left section comprises a stack of two resonators, a lower resonator 110 and an upper resonator 120 respectively, separated by at least one coupling acoustic layer 130, the coupling acoustic layer being possibly divided into coupling sub-layers.

As shown in the figure 4A, the LEFT structure (RIGHT respectively) comprises a lower resonator 110 (210 respectively) comprising a lower electrode 111 (211 respectively) and an upper electrode 113 (213 respectively) sandwiching a layer of piezoelectric material 112 (212 respectively).

The LEFT structure (RIGHT respectively) comprises further an upper resonator 120 (220 respectively) comprising a lower electrode 121 (221 respectively) and an upper electrode 123 (223 respectively) sandwiching a layer of piezoelectric material 122 (222 respectively).

The resonators are acoustic resonators of the *Bulk Acoustic Wave* (B.A.W.) type that are built by means of well known techniques such as thin film deposit technique, *sputtering techniques, vaporization under vacuum techniques, or Chemical Vapor Deposition (CVD) techniques.* Each resonator breaks down into a piezoelectric material and two electrodes, a lower electrode and an upper electrode respectively, sandwiching this layer. The piezoelectric material may be ZnO, AIN, ZnS or any other piezoelectric materials known from the man skilled in the art. The electrodes may be built in any metal suited to the sought application, such as for example tungsten (W), aluminum (Al), copper (Cu), molybdenum (Mo), nickel (Ni), titan (Ti), silver (Ag), gold (Au) or tantalum (Ta).

It should be noted that the steps for manufacturing the elements that are shown in figure 4A are similar to the method used for a conventional filter CRF and will not be accordingly described in further details.

To implement the impedance matching function, according to an embodiment of the invention, the two resonators 110 and 120 of the LEFT structure exhibit a common section A1, and two distinct thicknesses of piezoelectric material of respective values Wb and Wt.

The two resonators 210 et 220 of the RIGHT structure exhibit a common section A2, distinct from A1, as well as two distinct thicknesses of piezoelectric material of respective values Wb and Wt.

Conversely to the known CFR structure, the lower resonators of the two left and right are not connected to each other.

According to an embodiment of the invention, the lower resonator 110 of the left structure is connected to the upper resonator 220 of the right structure by means of metallic vias 300 et 400. The metallic via 300 enables thus to connect the lower electrode 111 of the resonator 110 to the lower electrode 221 of the resonator 222, while the metallic via 400 ensures the connection of the upper electrode 113 of the resonator 110 to the upper electrode 223 of the resonator 222.

For this topology, the resonators 120 et 210 act respectively as an input resonator and an output resonator of the filtering circuit.

The left structure of the filtering circuit is thus connected to its corresponding right structure through two resonators, 110 and 220 respectively, that exhibit concurrently a distinct section (A1, A2 respectively) and a distinct thickness of piezoelectric material (Wb, Wt).

Thus, it becomes possible to suitably select the values of the active surface areas of the sections A1 and A2, as well as the values of the thicknesses Wb and Wt to guarantee a perfect matching in electrics terms between the resonators 110 et 220. In order to implement an impedance matching in a ratio of two, in the case of an electric circuit of the type 50 $\Omega$ - 100 $\Omega$, it may be selected the following ratios between the thicknesses Wb et Wt and the reference areas of the sections A1 et A2:

$$Wb = Wt \times \sqrt{2}$$

$$A1 = A2 \times \sqrt{2}$$

It is thus observed that if the resonator 110 has a section area more important than the section area of the resonator 220, its thickness of dielectric material is however reduced in the same ratio, thus ensuring an electric impedance identical. The frequency alignment between the upper and lower resonators in each section is achieved by adjusting for example the thicknesses of the electrodes associated to each piezoelectric layer.

The figure 4B illustrates an equivalent scheme of such a structure, showing the impedance matching between the sections for a CRF filter that has input impedance of 50 $\Omega$ and an output impedance of 100 $\Omega$.

The figures 4C et 4D illustrate a particular embodiment of a stack of layers and of a layout, that enables to build a filtering circuit with an impedance transformation ratio equal to two. The resonators are built from Mo for the electrodes and from AIN for the piezoelectric layer. The coupling layers are made of tungsten (W) as well as of silicon dioxide (SiO$_2$).

The figure 4E compares the electric responses of the CRF filter with an impedance transformation according to the known embodiment (figure 2A) and an impedance transformation according to the said invention (figure 4D).

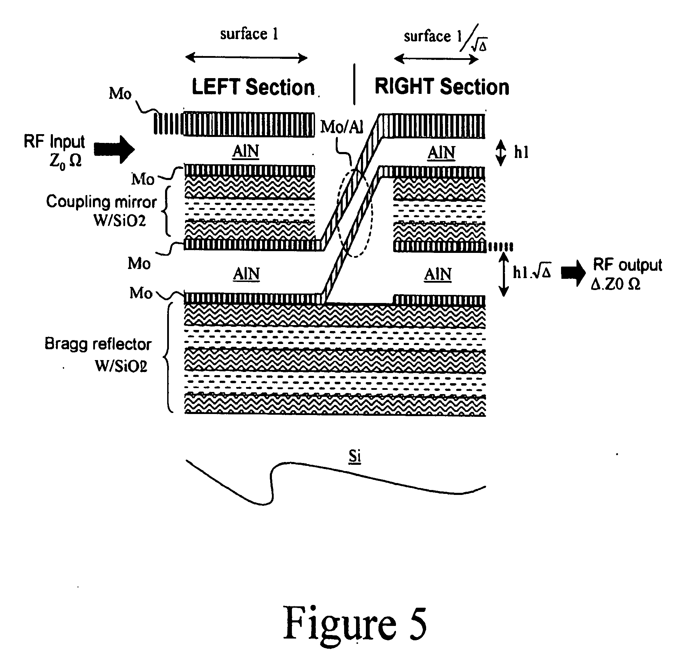

The Figure 5 illustrates a particular embodiment of a filtering circuit wherein the desired impedance transformation ratio $\Delta$ has been illustrated. In this particular embodiment, it is observed that the impedance transformation is implemented by increasing of $\sqrt{\Delta}$ ratio the thickness of the lower piezoelectric layer while the area of the section of the right part has been reduced in the same ratio $\sqrt{\Delta}$.

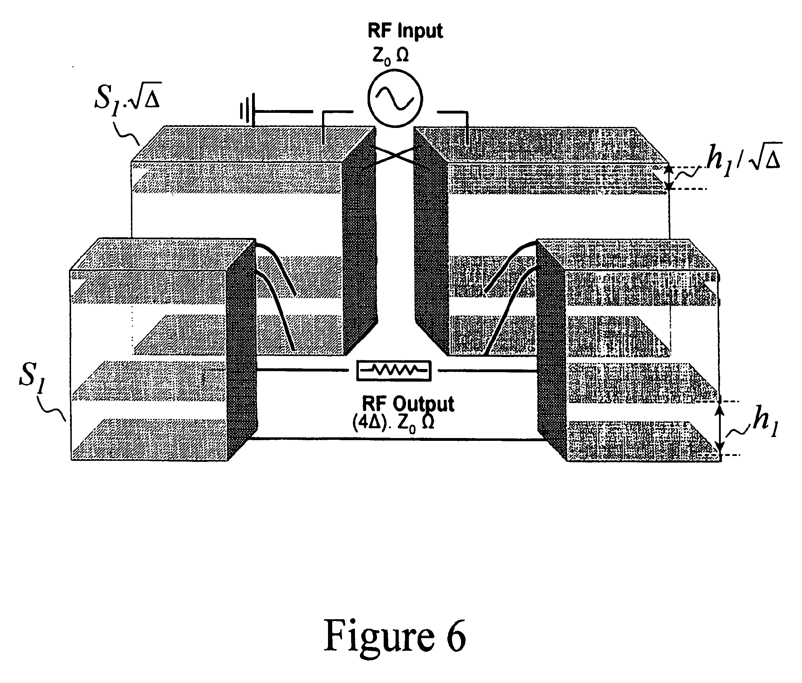

The structure of the figure 6 is based on the use of the embodiment of the said invention combined with the known embodiment for increasing the impedance transformation ratio. The illustrated example is CRF filter with two paths made of two sections that has an input impedance of 50 $\Omega$ and an output impedance of 4$\Delta$ x 50 $\Omega$. The transformation ratio $\Delta$ is achieved by the said invention.

In order to highlight the interest and the advantages of the invention, it is useful to turn back to two important technical effects.

**1. Release of the constraints exerted on the manufacturing process**

As described above, the CFR filtering circuit comprises two left and right sections, each section comprising a stack of two piezoelectric resonators, and at least a direct connection between a lower resonator of a section and an upper resonator of the other section.

This specificity of implementation of the filtering circuit offers an important advantage on the manufacturing process..

So it has been observed that the dispersions caused by the manufacturing process resulting in variations between the different layers - in particular the piezoelectric layers, the electrodes or the coupling layers - had effect to introduce a frequency offset between the lower and upper resonators of each of the structures. It results from that a modification of the acoustic coupling between the two resonance modes in each section and an alteration of the electrical response. This problem is well known from the man skilled in the art and will not be detailed.

Important constraints condition therefore the manufacturing process that must be able to implement layers exhibiting a very high accuracy in terms of thickness.

These constraints are illustrated in the figure 7A wherein a light dispersion may render a filtering circuit perfectly fully not compliant with filtering outlines defined by a standard. The figure 7B shows the evolution of the transformation ratio (initially close to 1) exhibited by a filter section that has for example a technological dispersion until to 5% on the coupling layer.

The new structure which is proposed allows significant releasing of these constraints. Indeed, the figure 7C shows the evolution of the electrical response of a filter with a technological dispersion up to 5% on a coupling layer. Comparing to figure 7A, it is clearly observed that the dispersion effect is minimized. It is evidenced that in spite of the dispersion the circuit remains within the desired filtering outlines.

The figure 7D shows the evolution of the reflection response of a filter that has technological dispersion up to 5% on the coupling layer. On the left, it is shown the obtained response for a circuit of the figure 4A. On the right, it is shown the obtained response for a conventional filter.

As evidenced, the use of the structure according to the invention results in releasing significantly the constraints on the manufacturing process so offering perspectives of low cost manufacturing.

## 2. Impedance matching

The CRF filtering circuit according to the invention comprises two sections, left and right, each section comprising a stack of two acoustic resonators, and at least a direct connection between a lower resonator of a section and an upper resonator that may exhibit a different active surface area as well as a different thickness of the piezoelectric layer.

As described above, when the surface area of the resonators of the right section is modified, as it is known, to achieve an impedance transformation (for example 50-100 Ohms, or 50-200 ohms) between the input and the output, it has been seen that a mismatching was created at the level of the electric connection of the lower resonators of the left and right sections.

Indeed, the lower resonators of the left and right sections having a different area, it results thereof a different equivalent capacitance and therefore the creation of an impedance mismatch.

The new structure shown in figure 5 solves this problem by implementing a connection between the lower left resonator and the upper resonator the piezoelectric electric thereof does not result from the same manufacturing process as carried out for the layer of the lower left resonator and is able to exhibit therefore a different thickness of the piezoelectric material.

It results thereof that it twill be possible to merely modify the thicknesses of the piezoelectric layers of these two resonators and the active surface area of each section, in order to reestablish the impedance matching between these two resonators. The frequency alignment between the upper and lower resonators in each section is obtained by adjusting for example the thicknesses of the electrodes associated to each piezoelectric layer.

This degree of freedom provided now allows envisaging all the impedance matching combinations without supplemental electric losses, therefore to increase significantly the application field of the new CFR structure that is proposed.

Such a disposal allows improving neatly the filtering circuit performance since it is possible to suppress the losses caused by the mismatching between the sections that was observed previously.

The structure that has been described here above has important advantages since it allows on one hand to significantly release the constraints on the manufacturing process and on the other hand to offer a large interval of impedance transformation ratios between the input and the output of the filter.

It will be described now in relation to the figure 8 the manufacturing process of a filtering circuit according to the present invention.

The invention allows the implementation of an efficient filter with coupled resonators by means of a method that is based for a large part on the existing process for manufacturing a known CRF filter.

For this purpose, the method comprises the following steps:

In a step 701, a substrate 100 destined to receive the structures of resonators is prepared. Possibly, the substrate will be prepared to receive other structures of MOS type well known from the man skilled in the art.

In a step 702, an acoustic mirror 101 is disposed above the substrate according to known methods. An alternative way is to implement a membrane to isolate acoustically the device from the substrate.

In a step 703, a first metallic layer is disposed that is etched to implement the lower electrodes 111 and 211, respectively, of the figure 6.

In step 704, a piezoelectric material is disposed, such as AIN destined to implement the layers 112 and 212.

In a step 705, a second metallic layer is disposed that is etched then to implement the electrodes 213 and 223.

In a step 706, one or more layers of acoustic coupling materials 130 are disposed.

In a step 707, it is disposed a third metallic layer destined to form the lower electrodes (121, 221) of the upper resonators 120 and 220.

In a step 708, it is disposed a second piezoelectric layer destined to implement the layers 122 and 222.

In a step 709, it is disposed a fourth metallic layer destined to implement the upper electrodes 123 and 223 that are etched to delimit the two left and right structures.

The operation is supplemented by a passivation step, then in step 710 two vias are implemented destined to build "through" inter-stage connections 300 and 400 between the left structure and the right structure.

It should be noticed that the deposit steps phases are known steps in the state in the art by depositing a thin film, by sputtering, by vaporizing under vacuum or by Chemical Vapor Deposition (CVD).

Also, the etching steps are carried out by means of etching techniques of dry or wet etching that are well known from the man skilled in the art which it is not necessary to describe further.

The invention has advantageously an application in mobile telephony, particularly in the implementation of pass-band filters destined to discriminate accurately two frequency bands particularly close to each other.

## Claims

1. Filtering circuit with coupled resonators comprising :

    - a substrate (100);
    - an acoustic mirror (101) or a membrane destined to act as a support of piezoelectric resonators, and to isolate them from the substrate ;
    - a first structure (LEFT) comprising an upper resonator (120) and a lower resonator (110) coupled to each other by means of at least one acoustic coupling layer (130), the said upper and lower resonators having a first section (A1) ;
    - a second structure (RIGHT) comprising an upper resonator (220) and a lower resonator (210) coupled to each other by means of at least one acoustic coupling layer (230), the said upper and lower resonators of the said second structure having a second section (A2) ;

    **characterized in that** it comprises metallic vias implementing an inter-stage connection between the lower resonator of a section and the upper resonator of the other section.

2. Filtering circuit with coupled resonators according to claim 1, **characterized in that** the said upper resonators have a piezoelectric layer with a selected thickness different from the thickness of the lower resonators and **in that** the section A1 has a different surface area from the section A2, in order to implement an impedance matching between the said first and second sections.

3. Filtering circuit according to claim 1 or 2, **characterized in that** the resonators are resonators of the Bulk Acoustic Wave (B.A.W.) type.

4. Filtering circuit according to claim 3, **characterized in that** the said resonator of BAW type are built by techniques of thin film deposition, of sputtering , of vaporization under vacuum or of chemical Vapor Deposition (CVD).

5. Filtering circuit according to any claims 1 to 4, **characterized in that** the resonators of the BAW type comprise a piezoelectric material that may be ZnO, AIN, ZnS.

6. Filtering circuit according to any of the claims 1 to 5, **characterized in that** the resonators comprise electrodes made of, for example, tungsten (W), aluminum (Al), copper (Cu), molybdenum (Mo), nickel (Ni), titan (Ti), silver (Ag), gold (Au) or tantalum (Ta).

7. Filtering circuit according of any of preceding claims, **characterized in that** it is used to implement a reception or transmission circuit for the mobile telephony.

8. Method for manufacturing a filtering circuit with coupled resonators comprising the following steps:

    - providing a substrate (100);
    - disposing an acoustic mirror (101) or a membrane above the substrate;
    - disposing a first (LEFT) section and a second (RIGHT) section, each section comprising a lower resonator (110, 210) with electrodes and a piezoelectric layer and an upper resonator (120, 220), the said lower and upper resonators being separated by at least one acoustic coupling layer (130, 230), the said first and second sections being connected by metallic vias ensuring an inter-stage connection between a lower resonator of a structure and an upper resonator of the other structure.

9. Method for manufacturing according to the claim 8, **characterized in that** it comprises:

    - arrangement of a first metallic layer destined to the implementation of the lower electrodes of the lower resonators of the said first and second sections (211, 221) ;
    - arrangement of a first piezoelectric layer (111);
    - arrangement of a second metallic layer destined to the implementation of the upper electrodes of the lower resonators of the said first and second sections (213) ;
    - arrangement of one or more layers of acoustic coupling materials (130), the said layer ensuring the critical coupling between the superimposed resonators ;
    - arrangement of a third metallic layer destined to implement lower electrodes of the upper resonators of the saic first and second sections (121, 221) ;
    - arrangement of a second piezoelectric layer (122, 222) ;
    - arrangement of a fourth metallic layer destined to implement the upper electrodes of the upper resonators of the said first and second sections (123 , 223) ;
- arrangement of the two left and right structures of the filtering circuit;
- arrangement of at least one via of metallic connection between an electrode of the lower resonator of a structure and an electrode of the upper resonator of the other structure.

10. Method according to claim 9, **characterized in that** the resonators of BAW type comprise a piezoelectric material that may be ZnO, AlN, ZnS.


**Patentansprüche**

1. Filter-Schaltung mit gekoppelten Resonatoren, umfassend:

- ein Substrat (100);
- einen akustischen Spiegel (101) oder eine Membran, die beschaffen ist, als Träger für piezoelektrische Resonatoren zu dienen und diese von dem Substrat zu trennen;
- eine erste Struktur (LEFT) umfassend einen oberen Resonator (120) und einen unteren Resonator (110), die miteinander durch mindestens eine akustische Kopplungs-Schicht (130) verbunden sind, wobei die oberen und unteren Resonatoren einem ersten Abschnitt (A1) aufweisen;
- eine zweite Struktur (RIGHT) umfassend einen oberen Resonator (220) und einen unteren Resonator (210), die miteinander durch mindestens eine akustische Kopplungs-Schicht (230) verbunden sind, wobei die oberen und unteren Resonatoren der zweiten Struktur einen zweiten Abschnitt (A2) aufweisen;

**gekennzeichnet durch** metallische Durch-Kontaktierungen, die eine Zwischen-Verbindung zwischen dem unteren Resonator eines Abschnitts und dem oberen Resonator des anderen Abschnitts herstellen.

2. Filter-Schaltung mit gekoppelten Resonatoren nach Anspruch 1, **dadurch gekennzeichnet, dass** die oberen Resonatoren eine piezoelektrische Schicht mit einer ausgewählten Dicke aufweisen, die unterschiedlich zu der Dicke der unteren Resonatoren ist, und dass der Abschnitt A1 eine vom Bereich A2 verschiedene Oberfläche aufweist, um eine Impedanz-Anpassung zwischen dem ersten und dem zweiten Abschnitten herzustellen.

3. Filter-Schaltung nach Anspruch 1 oder 2, **dadurch gekennzeichnet, dass** die Resonatoren vom Resonator-Typ Bulk-Acoustic-Wave (BAW-Typ) sind.

4. Filter-Schaltung nach Anspruch 3, **dadurch gekennzeichnet, dass** die Resonatoren vom BAW-Typ durch Techniken der Dünnschicht-Abscheidung, des Sputtern, der Verdampfung unter Vakuum oder der chemischen Gasphasen-Abscheidung (CVD) aufgebaut sind.

5. Filter-Schaltung nach einem der Ansprüche 1 bis 4, **dadurch gekennzeichnet, dass** die Resonatoren vom BAW-Typ ein piezoelektrisches Material aufweisen, das ZnO, AlN, ZnS sein kann.

6. Filter-Schaltung nach einem der Ansprüche 1 bis 5, **dadurch gekennzeichnet, dass** die Resonatoren Elektroden aufweisen, die beispielsweise Wolfram (W), Aluminium (Al), Kupfer (Cu), Molybdän (Mo), Nickel (Ni), Titan (Ti), Silber (Ag), Gold (Au) oder Tantal (Ta) gefertigt sind.

7. Filter-Schaltung nach einem der vorhergehenden Ansprüche, **dadurch gekennzeichnet, dass** er verwendet wird, um eine Empfangs- oder Übertragungs-Schaltung für die mobile Telefonie zu implementieren.

8. Verfahren zum Herstellen einer Filter-Schaltung mit gekoppelten Resonatoren, umfassend die folgenden Schritte:

- Bereitstellen eines Substrats (100);
- Anordnen eines akustischen Spiegels (101) oder einer Membran über dem Substrat;
- Anordnen eines ersten (LEFT) und eines zweiten (RIGHT) Abschnitts, wobei jeder Abschnitt einen unteren Resonator (110, 210) mit Elektroden und eine piezoelektrische Schicht und einen oberen Resonator (120, 220) aufweist, wobei die unteren und oberen Resonatoren durch mindestens eine akustische Kopplungs-Schicht (130, 230) getrennt werden, wobei die ersten und zweiten Abschnitte durch metallische Durch-Kontaktierungen verbunden werden, die eine Zwischen-Verbindung zwischen einem unteren Resonator einer Struktur und einem oberen Resonator der anderen Struktur sicherstellen.

9. Verfahren zur Herstellung gemäß Anspruch 8, **dadurch gekennzeichnet, dass** es umfasst:

- Anordnen einer ersten metallischen Schicht, die beschaffen ist zur Implementierung der unteren Elektroden der unteren Resonatoren der ersten und zweiten Abschnitte (211, 221);
- Anordnen einer ersten piezoelektrischen Schicht (111);
- Anordnung einer zweiten metallischen Schicht, die beschaffen ist zur Implementierung der oberen Elektroden der unteren Resonatoren der ersten und zweiten Abschnitte (213);
- Anordnung einer oder mehrerer Schichten aus Materialien für akustische Kopplung (130), wobei die Schicht die kritische Kopplung zwischen den überlagerten Resonatoren sicherstellt;
- Anordnung eines dritten metallischen Schicht, die beschaffen ist zur Implementierung der unteren Elektroden der oberen Resonatoren der ersten und zweiten Abschnitte (121, 221);
- Anordnung einer zweiten piezoelektrischen Schicht (122, 222);
- Anordnung einer vierten metallischen Schicht, die beschaffen ist zur Implementierung der oberen Elektroden der oberen Resonatoren der ersten und zweiten Abschnitte (123, 223);
- Anordnung der beiden linken und rechten Strukturen der Filter-Schaltung;
- Anordnung von mindestens einer Durchkontaktierung einer metallischen Verbindung zwischen einer Elektrode des unteren Resonators einer Struktur und einer Elektrode des oberen Resonators der anderen Struktur.

10. Verfahren nach Anspruch 9, **dadurch gekennzeichnet, dass** die Resonatoren von BAW-Typ ein piezoelektrisches Material aufweisen, das ZnO, AlN, ZnS sein kann.

**Revendications**

1. Circuit de filtrage à résonateur couplés comportant :

   - un substrat (100) ;
   - un miroir acoustique (101) ou une membrane destinés à servir de support à des résonateurs piézoélectriques, et les isoler du substrat ;
   - une première structure (GAUCHE) comportant un résonateur supérieur (120) et un résonateur inférieur (110) couplés l'un à l'autre au moyen d'au moins une couche de couplage acoustique (130), lesdits résonateurs supérieur et inférieur présentant une première section (A1) ;
   - une seconde structure (DROITE) comportant un résonateur supérieur (220) et un résonateur inférieur (210) couplés l'un à l'autre au moyen d'au moins une couche de couplage acoustique (230), lesdits résonateur supérieur et inférieur de ladite seconde structure présentant une seconde section (A2) ;

   **caractérisé en ce qu'**il comporte des vias métalliques réalisant une connexion inter étage entre le résonateur inférieur d'une section et le résonateur supérieur de l'autre section.

2. Circuit de filtrage à résonateur couplés selon la revendication 1 **caractérisé en ce que** lesdits résonateurs supérieurs présentent une couche piézoélectrique ayant une épaisseur choisie différente de celle des résonateurs inférieurs et que la section A1 dispose d'une surface différente de la section A2, de manière à réaliser une adaptation d'impédance entre lesdites premières et secondes sections.

3. Circuit de filtrage selon la revendication 1 ou 2 **caractérisé en ce que** les résonateurs sont des résonateurs de type Bulk Acoustic Wave (B.A.W.).

4. Circuit de filtrage selon la revendication 3 **caractérisé en ce que** lesdits résonateurs de type BAW sont réalisés par des techniques de dépôt de couches minces, de pulvérisation, d'évaporation sous vide ou de dépôt de vapeur chmique CVD.

5. Circuit de filtrage selon l'une quelconque des revendications 1 à 4, **caractérisé en ce que** les résonateurs de type BAW comportent un matériau piezoelectrique qui peut être ZnO, AlN, ZnS.

6. Circuit de filtrage selon l'une quelconque des revendications 1 à 5 **caractérisée en ce que** les résonateurs comportent des électrodes composées par exemple de tungstène (W), de l'aluminium (Al), du cuivre (Cu), du molybdène (Mo), du nickel (Ni), du titane (Ti), de l'argent (Ag), de l'or (Au) ou du tantale (Ta).

7. Circuit de filtrage selon l'une quelconque des revendications précédentes, **caractérisée en ce qu'**il est destiné à la réalisation d'un circuit de réception ou d'émission pour téléphonie mobile.

8. Procédé de fabrication d'un circuit de filtrage à résonateurs couplés comportant les étapes suivantes :

   - disposer un substrat (100) ;
   - disposer un miroir acoustique (101) ou d'une membrane au dessus du substrat;
   - disposer une première (GAUCHE) et une seconde (DROITE) section comportant chacune un résonateur inférieur (110, 210) disposant d'électrodes et d'une couche piézo-électrique et un résonateur supérieur (120, 220), lesdits résonateurs inférieurs et supérieurs étant séparés par au moins une couche de couplage acoustique (130, 230), lesdites première et seconde sections étant connectées au moyen de vias métalliques assurant une connexion inter-étage entre un résonateur inférieur d'une structure et un résonateur supérieur de l'autre structure.

9. Procédé de fabrication selon la revendication 8 **caractérisé en ce qu'**il comporte :

- la disposition d'une première couche métallique destinée à la réalisation des électrodes inférieures des résonateurs inférieurs desdites première et seconde sections (211, 221) ;

- disposition d'une première couche piézo-électrique (111) ;

- la disposition d'une seconde couche métallique destinée à la réalisation des électrodes supérieures des résonateurs inférieurs desdites première et seconde sections (213) ;

- la disposition d'une ou plusieurs couches de matériaux de couplage acoustique (130), ladite couche assurant le couplage critique entre les résonateurs supperposés.

- la disposition d'une troisième couche métallique destinée à la réalisation des électrodes inférieures des résonateurs supérieurs desdites première et seconde sections (121, 221) ;

- la disposition d'une seconde couche piézo-électrique (122, 222) ;

- la disposition d'une quatrième couche métallique destinée à la réalisation des électrodes supérieures des résonateurs supérieurs desdites première et seconde sections (123 , 223) ;

- la délimitation des deux structures gauche et droite du circuit de filtrage ;

- la disposition d'au moins un via de connexion métallique entre une électrode du résonateur inférieur d'une structure et une électrode du résonateur supérieur de l'autre structure.

10. Procédé selon la revendication 9 **caractérisé en ce que** les résonateurs de type BAW comporte un matériau piézo-électrique qui peut être ZnO, AlN, ZnS.

Fig 1A

Fig 1B

TOP VIEW

RF output
50Ω

RF output
100Ω

2nd stage

1st Stage

elementary
surface

RF input
50Ω

RF input
50Ω

upper electrode of
upper resonators

lower electrode of
upper resonators

upper electrode of
of lower resonators

lower electrode of
upper resonators

Figure 2 A

LEFT Section          RIGHT Section

input  50 Ω        50        100        output  100 Ω

50 Ω  ➤ 100 Ω

mis-matching of impedance

# Figure 2 B

Figure 2 C

Assymetric input
50 Ω

Differential output 200 Ω

section 100 Ω

48

44

42

47

45 46

40

43

41

Figure 3 A

EP 2 377 245 B1

**Figure 3 B**

Figure 4 A

EP 2 377 245 B1

Crossing vias

Input 50 Ω    Output 100 Ω

*50*    *~71*    *~71*    *100*

~71 Ω ➤ ~71 Ω

LEFT Section    RIGHT Section

# Figure 4 B

Figure 4 C

**RF output**

**100Ω**

**2nd stage**

**1st Stage**

elementary
surface

**RF input**

**50Ω**

upper electrode of
upper resonators

lower electrode of
upper resonators

upper electrode of
of lower resonators

lower electrode of
upper resonators

metallization
crossing via

etching

# Figure 4 D

## Figure 4 E

Figure 5

**RF Input**
$Z_0\ \Omega$

$S_1.\sqrt{\Delta}$

$h_1/\sqrt{\Delta}$

$S_1$

**RF Output**
$(4\Delta).\ Z_0\ \Omega$

$\sim h_1$

Figure 6

Figure 7 A

Figure 7 B

Figure 7.C

Figure 7.D

```
┌─────────────────────────────────┐
│   Preparation of substrate 100  │
└─────────────────────────────────┘
                 │                        701
                 ▼
┌─────────────────────────────────┐
│   arrangement of acoustic mirror│
└─────────────────────────────────┘
                 │                        702
                 ▼
┌─────────────────────────────────┐
│   arrangement of metallic layer │
│ for carrying out electrodes 111 and 211│
└─────────────────────────────────┘
                 │                        703
                 ▼
┌─────────────────────────────────┐
│ Arrangement of first piezzo-electric layer│
└─────────────────────────────────┘
                 │                        704
                 ▼
┌─────────────────────────────────┐
│ Arrangement of a second metallic layer│
│   to carry out electrode 213 & 223│
└─────────────────────────────────┘
                 │                        705
                 ▼
┌─────────────────────────────────┐
│   Arrangement of at least an    │
│     acoustic coupling layer     │
└─────────────────────────────────┘
                 │                        706
                 ▼
┌─────────────────────────────────┐
│   arrangement of third metallic │
│         layer 121, 221          │
└─────────────────────────────────┘
                 │                        707
                 ▼
┌─────────────────────────────────┐
│     Arrangement of a second     │
│  piezo-electric layer (122, 222)│
└─────────────────────────────────┘
                 │                        708
                 ▼
┌─────────────────────────────────┐
│   Arrangement of fourth metallic│
│         layer 123, 223          │
└─────────────────────────────────┘
                 │                        709
                 ▼
┌─────────────────────────────────┐
│   creation of vias & metallic   │
│    connexions 300 & 400         │
└─────────────────────────────────┘
                                          710
```

# Figure 8

**EP 2 377 245 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005046052 A1

- EP 1528675 A

**Non-patent literature cited in the description**

- **K.M. LAKIN.** Bulk Acoustic Wave Coupled Resonators Filters. *IEEE International Frequency Control Symposium,* 2002, 8A-1

- **K.M. LAKIN.** *Coupled Resonators Filters,* 08 October 2002